(19) Europäisches Patentamt
European Patent Office
Office européen des brevets

(11) **EP 1 947 748 A1**

(12) **EUROPEAN PATENT APPLICATION**

(43) Date of publication:
**23.07.2008 Bulletin 2008/30**

(51) Int Cl.:
*H01S 5/06* [(2006.01)]  *H01S 5/14* [(2006.01)]
*H01S 5/026* [(2006.01)]  *H01S 5/183* [(2006.01)]

(21) Application number: **07118240.6**

(22) Date of filing: **10.10.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **17.01.2007 KR 20070005422**

(71) Applicant: **Samsung Electronics Co., Ltd Suwon-si, Gyeonggi-do 443-742 (KR)**

(72) Inventors:
• **Mun, Yong-kweun**
  **Gyeonggi-do (KR)**
• **Won, Jong-hwa**
  **Gyeonggi-do (KR)**

(74) Representative: **Greene, Simon Kenneth Elkington and Fife LLP Prospect House 8 Pembroke Road Sevenoaks, Kent TN13 1XR (GB)**

(54) **Speckle reduction laser**

(57)     Provided is a speckle reduction laser that emits laser light by resonating light generated from an active layer (134,240). The speckle reduction laser includes a mode changing unit (150,260) having an electro-optical material layer (155,261) disposed in a resonance path of the laser light, wherein a resonance mode of the laser light is changed when a voltage is applied to the electro-optical material layer (155,261).

The last resonator may in addition include a high reflection mirror (120), an AR layer (140) and a partly reflecting mirror (160). The laser active part may be an edge-emitter (130) or a VCSEL.

FIG. 4

**Description**

## BACKGROUND OF THE INVENTION

Apparatus consistent with the present invention relate to a speckle reduction laser, and more particularly, to a speckle reduction laser that reduces speckles by changing a resonance mode.

With rapid emergence of the multi-media society, demands for displaying large images of high definition have constantly increased. Also, recent multi-media advancements provide for the realization of a more natural color in addition to displaying large images of high resolution.

In order to realize a more natural color, it is essential to use a light source such as a laser having high color purity. However, when an image is realized using the laser as a light source, the image quality is degraded due to speckles caused by coherence of laser light. The speckles are an arbitrary interference pattern of light, that is, noise formed on the retina of a viewer by entering light which is scattered due to the surface roughness of a screen when the laser light is reflected at the surface of the screen.

## SUMMARY OF THE INVENTION

The present invention provides a speckle reduction laser that can reduce speckles by changing a resonance mode using an electro-optical material.

According to an aspect of the present invention, there is provided a speckle reduction laser that emits laser light by resonating light generated from an active layer, the speckle reduction laser comprising a mode changing unit having an electro-optical material layer disposed in a resonance path of the laser light, wherein a resonance mode of the laser light is changed when a voltage is applied to the electro-optical material layer.

The speckle reduction laser may have an edge emitting type laser resonance structure in which light is emitted from the side surface of a semiconductor unit that comprises the active layer.

The variation width of the resonance mode of the laser light may be equal to or smaller than a resonance modes spacing when the variation width of the resonance mode is viewed in a frequency spectrum.

The mode changing unit may be provided on a side surface of the semiconductor unit.

The speckle reduction laser may further comprise a reflection mirror on other side surface of the semiconductor unit facing the side surface of the semiconductor unit where the mode changing unit is formed.

The speckle reduction laser may further comprise a half mirror on a surface opposite to the surface of the mode changing unit facing the semiconductor unit, and the laser light may be emitted through the half mirror.

The speckle reduction laser may further comprise a reflection mirror on a surface opposite to the surface of the mode changing unit facing the semiconductor and a half mirror on the other side surface opposite to the side surface of the semiconductor unit where the mode changing unit is formed, and the laser light may be emitted through the half mirror.

The speckle reduction laser may further comprise a antireflective member interposed between the semiconductor unit and the mode changing unit.

The electrode that applies a voltage to the electro-optical material layer may be provided on at least one surface of the surfaces that surround the resonance path of the electro-optical material layer.

The speckle reduction laser may have a vertical cavity surface emitting laser (VCSEL) structure in which an upper reflection layer and a lower reflection layer are respectively provided on and under the active layer. In this case, the mode changing unit may be formed on or under the active layer.

The electro-optical material layer of the mode changing unit may be interposed between the active layer and the upper reflection layer. In this case, the speckle reduction laser may further comprise a current control layer interposed between the active layer and the electro-optical material layer and having an insulating region and a conductive region, wherein the electrode that applies a voltage to the electro-optical material layer is disposed between the insulating region and the electro-optical material layer.

The electro-optical material layer may be formed of K-Ta-Nb or $LiNbO_3$.

## BRIEF DESCRIPTION OF THE DRAWINGS

The above and other aspects of the present invention will become more apparent by describing in detail exemplary embodiments thereof with reference to the attached drawings, in which:

FIG. 1 is a schematic cross-sectional view of a speckle reduction laser according to an exemplary embodiment of the present invention;

FIG. 2 is a schematic perspective view of a semiconductor unit from which light of the speckle reduction laser of FIG. 1 is generated, according to an exemplary embodiment of the present invention;

FIG. 3 is a schematic perspective view of a mode changing unit of the speckle reduction laser of FIG. 1, according to an exemplary embodiment of the present invention;

FIG. 4 is a schematic cross-sectional view illustrating a location relationship between the semiconductor unit and the mode changing unit of FIG. 1, according to an exemplary embodiment of the present invention;

FIG. 5 is a schematic drawing showing an operation of the speckle reduction laser of FIG. 1, according to an exemplary embodiment of the present invention;

FIG. 6 is a graph showing a resonance mode change of the speckle reduction laser of FIG. 1, according to an exemplary embodiment of the present invention;

FIG. 7 is a schematic cross-sectional view of a speckle reduction laser according to another exemplary embodiment of the present invention; and

FIG. 8 is a schematic drawing showing the generation of an electric field of a mode changing unit of the speckle reduction laser of FIG. 7, according to another exemplary embodiment of the present invention.

## DETAILED DESCRIPTION OF EXEMPLARY EMBODIMENTS

The present invention will now be described more fully with reference to the accompanying drawings in which exemplary embodiments of the invention are shown.

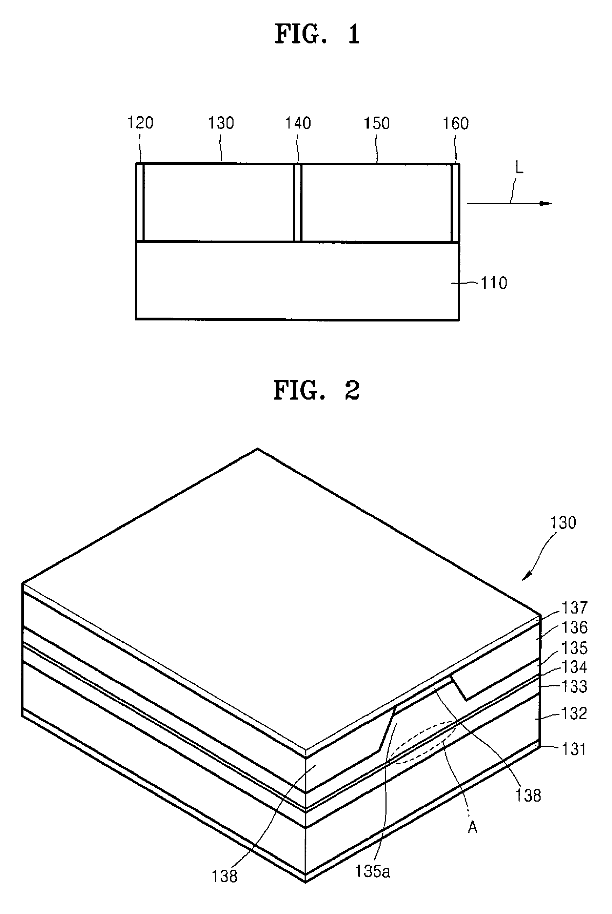

FIG. 1 is a schematic cross-sectional view of a speckle reduction laser according to an exemplary embodiment of the present invention.

Referring to FIG. 1, the speckle reduction laser according to an exemplary embodiment of the present invention includes a semiconductor unit 130 from which light is emitted and a mode changing unit 150 placed on a resonance path of laser light L, which are both placed on a mount 110. The semiconductor unit 130 according to the present exemplary embodiment has an edge emitting type laser resonance structure in which light is emitted from a side surface as depicted in FIG. 2. The mode changing unit 150 is provided on a side of the semiconductor unit 130 where the light is emitted.

Light generated from the semiconductor unit 130 is pumped between the semiconductor unit 130 and the mode changing unit 150, and a portion of the light is emitted through the mode changing unit 150. Thus, the other side surface of the semiconductor unit 130 facing the side surface of the semiconductor unit 130 where the mode changing unit 150 is provided may have high reflectance. For this purpose, a reflection mirror 120 is disposed on the other side surface of the semiconductor unit 130. A half mirror 160 may be disposed on a surface opposite to the surface of the mode changing unit 150 facing the semiconductor unit 130. In this way, due to the structure having the reflection mirror 120 and the half mirror 160, the loss of laser light L through the other side surface of the semiconductor unit 130 can be minimized when the laser light L is resonated. The reflection mirror 120 and the half mirror 160 are well known in the side surface emission type semiconductor laser technical fields, and thus, the detailed description thereof will be omitted.

A antireflective member 140 may further be interposed between the semiconductor unit 130 and the mode changing unit 150 to minimize the loss of the laser light L at an interface between the semiconductor unit 130 and the mode changing unit 150 when the laser light L is resonated between the reflection mirror 120 and the half mirror 160. The antireflective member 140 is a refractive index matching member formed of at least one dielectric layer, and prevents the light from being reflected at the interface between the semiconductor unit 130 and the mode changing unit 150 by appropriately controlling the refractive index and thickness thereof when the light enters the mode changing unit 150 from the semiconductor unit 130 or vice versa. The antireflective member 140, which corresponds to a coating film for preventing reflection, is well known in the art, and thus, the detailed description thereof will be omitted.

Referring to FIG. 2, the semiconductor unit 130 has an edge emitting type laser resonance structure having a ridge structure. More specifically, an n-type clad/waveguide layer 133, an active layer 134, a p-type clad/waveguide layer 135 having a ridge portion 135a, a p-type contact layer 138, and a p-type electrode 137 are sequentially stacked on an n-type substrate 132, and an n-type electrode 131 is formed on a lower surface of the n-type substrate 132. An insulating layer 136 is formed on a side of the ridge portion 135a of the p-type clad/waveguide layer 135. Region A where light is emitted from the semiconductor unit 130 of the above ridge structure is limited to a region near the ridge portion 135a.

The structure of the semiconductor unit 130 described with reference to FIG. 2 is an example, and thus, the structure of the semiconductor unit 130 according to the present exemplary embodiment is not limited thereto. For example, instead of the n-type substrate 132, an insulating substrate such as a sapphire substrate can be employed. In this case, an n-type contact layer is interposed between the insulating substrate and the n-type clad/waveguide layer, a portion of the n-type contact layer is stepped, and an n-type electrode is formed in the stepped portion. The types of the clad/waveguide layers may be reversed.

When power is applied to the n-type electrode 131 and the p-type electrode 137, electrons and holes meet in the active layer 134 and generate light. The generated light forms a predetermined mode between the n-type clad/waveguide layer 133 and the p-type clad/waveguide layer 135, and thus, is emitted through the side. The region A in FIG. 2 indicates a region where light is emitted from the active layer 134.

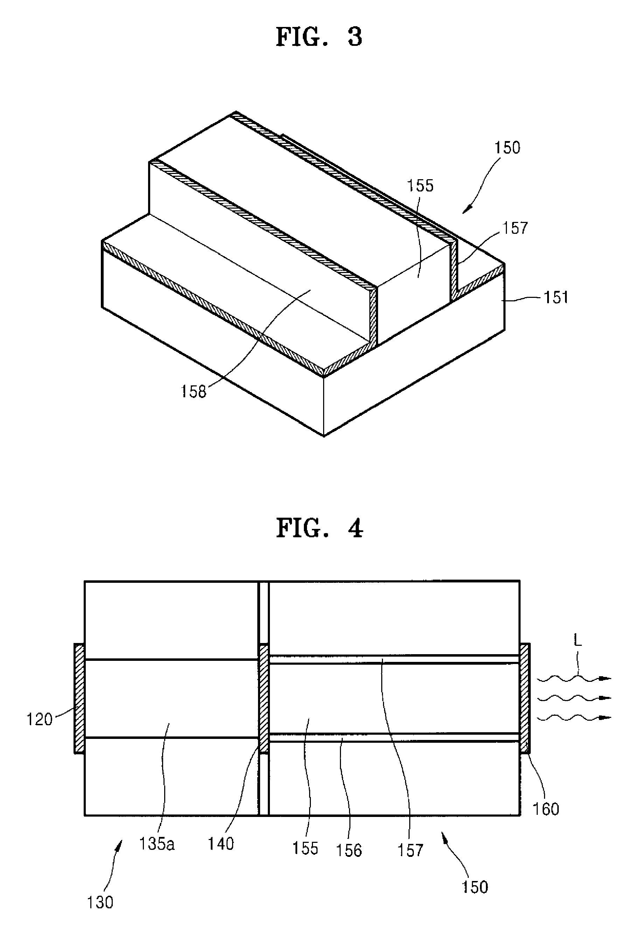

FIG. 3 is a schematic perspective view of a mode changing unit 150 of the speckle reduction laser of FIG. 1, according to an exemplary embodiment of the present invention. Referring to FIG. 3, the mode changing unit 150 includes an electro-optical material layer 155 provided on a sub-mount 151, and electrodes 157 and 158 formed on both lateral surfaces of the electro-optical material layer 155 to apply a voltage to the electro-optical material layer 155.

The electro-optical material layer 155 is formed of an optical crystal material that shows an electro-optic effect. The optical crystal material can be $LiNbO_3$ (hereinafter, LiNbO) or K-Ta-Nb (hereinafter, KTN).

When a voltage is applied to the electro-optical material layer 155, the refractive index of the optical crystal material is changed. Preferably, but not necessarily, the refractive index of the optical crystal material may be uniformly changed in the electro-optical material layer 155. This is because, when the refractive index is non-uniformly changed in the electro-optical material layer 155, a path of light that passes through the electro-optical material layer 155 can be bended. As it will be described later, the refractive index change of the electro-optical material layer 155 is given by a function of an electric filed being applied to the optical crystal material. Therefore, it may be required that the electric field applied to the electro-optical material layer 155 is uniform. However, the uniform electric field is not strictly required. As it will be described later, even when the optical path length in the electro-optical material layer 155 is formed to be very small, for example, approximately 1 mm or less, speckles can be sufficiently removed. In this case, bending of the optical path due to the non-uniform electric field can be substantially negligible.

The mode changing unit 150 according to the present exemplary embodiment has a structure in which the electro-optical material layer 155 is interposed between the two parallel electrodes 157 and 158, and electric charges are not injected into the electro-optical material layer 155 when a voltage is applied to the electrodes 157 and 158. Accordingly, the electric field applied to the electro-optical material layer 155 is uniform, and the refractive index is uniformly changed in the electro-optical material layer 155. The injection of charges into the electro-optical material layer 155 can be prevented by additionally forming an insulating layer between the electrodes 157 and 158, and the electro-optical material layer 155, or forming the electrodes 157 and 158 with a metal such as Pt.

The electro-optical material layer 155 is disposed to cover the region A (refer to FIG. 2) where light generated from the semiconductor unit 130 is emitted. That is, as shown in FIG. 4, the ridge portion 135a of the semiconductor unit 130 and the electro-optical material layer 155 of the mode changing unit 150 are arranged to contact each other so that light emitted from the semiconductor unit 130 can entirely enter the electro-optical material layer 155. At this point, the electro-optical material layer 155 can be a waveguide of the laser light "L" together with the n-type and p-type clad/ waveguide layers 133 and 135 of the semiconductor unit 130 (refer to FIG. 3).

In the present exemplary embodiment, the electrodes 157 and 158 are formed on both sides of the electro-optical material layer 155, but the present invention is not limited thereto. The electrodes 157 and 158 that apply a voltage to the electro-optical material layer 155 can be formed on a surface of the electro-optical material layer 155 except a side surface facing the semiconductor unit 130 and the other side surface where light is emitted, that is, at least one surface of the surfaces that surround the resonance path of the electro-optical material layer 155.

In the speckle reduction laser described with reference to FIGS. 1 and 2, the laser light output surface of the mode changing unit 150 is the side surface opposite to the other side surface facing the semiconductor unit 130, but the present invention is not limited thereto. For example, the other side surface of the semiconductor unit 130 facing the side surface of the semiconductor unit 130 where the mode changing unit 150 is provided can be the laser light output surface. In this case, the half mirror 160 may be formed on the other side surface of the semiconductor unit 130, and the reflection mirror 120 may be formed on the side surface opposite to the other side surface of the mode changing unit 150 facing the semiconductor unit 130. Thus, light generated from the active layer 134 of the semiconductor unit 130 is resonated between the reflection mirror 120 and the half mirror 160, and a portion of the light is emitted through the half mirror 160.

Also, the semiconductor unit 130 and the mode changing unit 150 described with reference to FIGS. 1 and 2 can be mounted on the mount 110 after being manufactured through separated processes, but the present invention is not limited thereto. The electro-optical material layer 155 of the mode changing unit 150 can be formed through a semiconductor manufacturing process. Therefore, the semiconductor unit 130 and the mode changing unit 150 can be manufactured in a batch process on a single wafer. In this case, the semiconductor unit 130 and the mode changing unit 150 are formed on one substrate which is the mount 110.

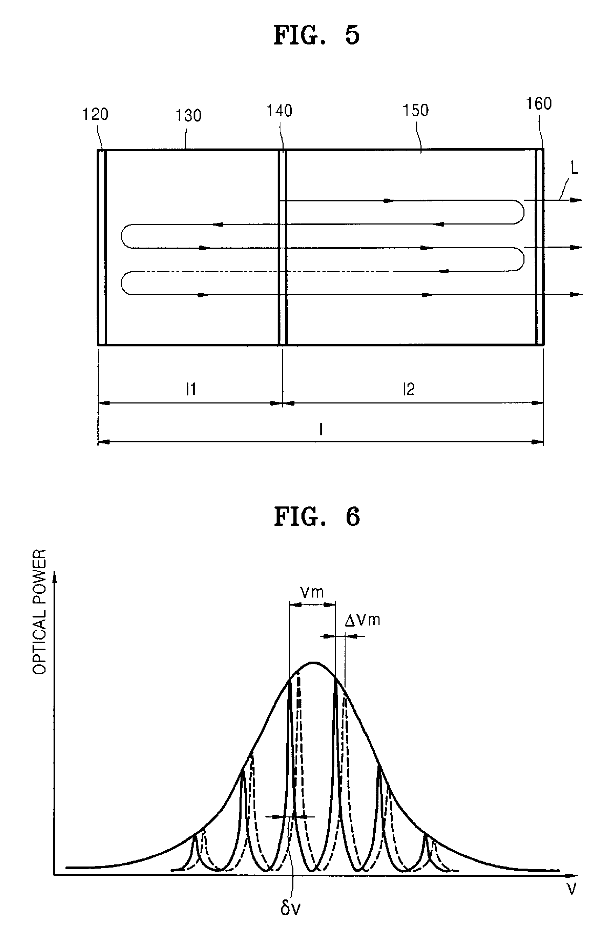

An operation of the speckle reduction laser according to an exemplary embodiment of the present invention will now be described with reference to FIGS. 5 and 6.

Referring to FIG. 5, light generated from the semiconductor unit 130 is emitted towards the mode changing unit 150, and enters the mode changing unit 150. The light that has entered in the mode changing unit 150 is reflected by the half mirror 160, and as a result, re-enters the semiconductor unit 130. The light that has re-entered the semiconductor unit 130 is re-reflected by the reflection mirror 120. The light that has re-reflected in the semiconductor unit 130 progresses towards the half mirror 160 passing through the semiconductor unit 130 and the mode changing unit 150, and reaches a laser light resonance mode through re-reflecting operations. In this way, the light generated from the semiconductor unit 130 is resonated between the semiconductor unit 130 and the mode changing unit 150, and a portion of the light is emitted through the half mirror 160 when the light is reflected or re-reflected by the half mirror 160.

In FIG. 5, I indicates a physical resonance distance of light generated from the semiconductor unit 130, $l_1$ indicates the length of the semiconductor unit 130, and $l_2$ indicates the length of the mode changing unit 150. At this point, the physical resonance distance I of light is the sum of the lengths $l_1$ and $l_2$ of the semiconductor unit 130 and the mode changing unit 150. However, the optical resonance distance of the generated light varies according to the variation of the refractive index of the mode changing unit 150. The optical resonance distance of light will be described later.

When a voltage is applied to the electro-optical material layer 155 (refer to FIG. 3) of the mode changing unit 150, the refractive index variation An of the electro-optical material layer 155 is obtained as an approximate value using equation 1.

[Equation 1]

$$\Delta n = \frac{1}{2} n_0^3 g_{eff} \varepsilon_0 \varepsilon_r E^2$$

where no is the refractive index of the electro-optical material layer 155 when a voltage is not applied to the electro-optical material layer 155, and $g_{eff}$ is a predetermined coefficient. $\varepsilon_0$ is a dielectric constant in a vacuum state, and $\varepsilon_r$ is a relative dielectric constant and denotes a ratio of the dielectric constant of the electro-optical material layer 155 with respect to the dielectric constant in the vacuum state. E is a voltage applied to the electro-optical material layer 155.

For example, when the electro-optical material layer 155 is formed of KTN, the factors of the refractive index variation $\Delta n$ are shown in Table 1 below.

[Table 1]

| $n_0$ | $g_{eff}$ | $\varepsilon_0$ | $\varepsilon_r$ |
|---|---|---|---|
| 2.3 | 0.2 C$^4$/m$^2$ | 8.86$\times$10$^{-12}$ F/m | 2$\times$10$^4$ |

Accordingly, when a voltage E of 300V/mm is applied, the refractive index variation $\Delta n$ has an approximately order of magnitude of 10$^{-2}$. When the electro-optical material layer 155 is formed of LiNbO, the refractive index variation An reaches an approximate order of magnitude of 10$^{-4}$.

The variation amount of a resonance mode according to the refractive index variation $\Delta n$ will now be described. The variation amount $\Delta v_m$ of a resonance mode which is viewed in a frequency spectrum is obtained using equation 2.

[Equation 2]

$$\Delta v_m = \frac{c}{\lambda_0} - \frac{c}{\lambda_0 + \Delta \lambda_0} = \frac{c}{\lambda_0} \left( 1 - \frac{l}{l + \Delta l} \right) = \frac{c}{\lambda_0} \frac{\Delta l}{l + \Delta l} ,$$

where c is light speed, $\lambda_0$ is a center laser wavelength, $\Delta \lambda_0$ is variation amount of the center laser wavelength according to the refractive index variation, I is resonance distance, and $\Delta l$ is optical resonance distance according to the refractive index variation.

Equation 2 denotes that the change of a resonance mode can occur according to the variation of the optical resonance distance although the physical resonance distance of light is not changed. The variation $\Delta l$ of the optical resonance distance is obtained using equation 3.

[Equation 3]

$$\Delta l = \Delta n \, l_2$$

where $l_2$ is the length of the mode changing unit 150 described with reference to FIG. 5.

Equation 3 denotes that the optical resonance distance can vary according to the variation of refractive index.

When Equations 2 and 3 are considered, it is seen that the refractive index of the electro-optical material layer 155 changes, and the resonance mode is changed when a voltage is applied to the electro-optical material layer 155. The change of the resonance mode is shown in FIG. 6. Referring to FIG. 6, the resonance mode indicated by a solid line changes into a resonance mode indicated by a dashed line as the refractive index varies.

The resonance mode can be changed with time by changing a voltage being applied to the electro-optical material layer 155 with time. The change of a resonance mode causes a change of speckle patterns. The speckles seen by a viewer are time-averaged speckles. The change of the speckles that occurs instantly reduces the speckle contrast through averaging the speckles by overlapping latent images of the speckle patterns. The refractive index variation of the electro-optical material layer 155 can be achieved in a short period of time by increasing the frequency of the voltage applied to the electro-optical material layer 155, and thus, the speckle reduction laser according to the present exemplary embodiment can reduce or remove the speckles.

The variation amount $\Delta v_m$ of a resonance mode may be equal to or smaller than a resonance mode spacing $v_m$. The approach of the variation amount $\Delta v_m$ of a resonance mode near the resonance mode spacing $v_m$ denotes that the mode change has occurred in the entire resonance region, and thus, a further mode change is unnecessary. The resonance mode spacing $v_m$ can be expressed using Equation 4 in a frequency spectrum.

[Equation 4]

$$v_m = \frac{c}{\lambda_n} - \frac{c}{\lambda_{n-1}} = \frac{c}{2l}\left(\frac{2l}{\lambda_n} - \frac{2l}{\lambda_{n-1}}\right) = \frac{c}{2l} \quad , n=0,1,2,...$$

For example, a designing condition of the mode changing unit 150 is reviewed when the semiconductor unit 130 has a length $l_1$ of 650 $\mu$m and the center laser wavelength $\lambda_0$ is 650 $\mu$m. If the length $l_2$ of the mode changing unit 150 is 1 mm, the resonance mode spacing $v_m$ is $9.1 \times 10^{10}$ Hz. Thus, the variation amount $\Delta v_m$ of the resonance mode may have an approximate order of magnitude of $10^{11}$. If the variation amount $\Delta l$ of the optical resonance distance is 1 $\mu$m, the variation amount $\Delta v_m$ of the resonance mode is $2.8 \times 10^{11}$. Thus, the required refractive index variation An of the electro-optical material layer 155 may have an approximate order of magnitude of $10^{-3}$. If the electro-optical material layer 155 is formed of KTN, an electric field of 30 V/mm must be applied to the electro-optical material layer 155 so that the electro-optical material layer 155 can have a refractive index variation $\Delta n$ of an approximate order of magnitude of $10^{-3}$. Accordingly, if the gap between the electrodes 157 and 158 is 1 mm, a voltage of 3V is sufficient to achieve the change of the resonance mode. When the electro-optical material layer 155 is formed of LiNbO having a large refractive index variation, the change of the resonance mode can be achieved by applying a lower voltage to the electro-optical material layer 155. That is, in case when the mode changing unit 150 has a length $l_2$ of approximately 1 mm or less, which is a similar order to the length $l_1$ of the semiconductor unit 130, a sufficient speckle reduction effect can be obtained. Also, a voltage required to be applied to the electro-optical material layer 155 to cause the change of the resonance mode of the speckle reduction laser according to the present exemplary embodiment is a few volts or less, and thus, the speckle reduction laser according to the present exemplary embodiment can be readily applied to related art electronic circuits that usually use a few volts.

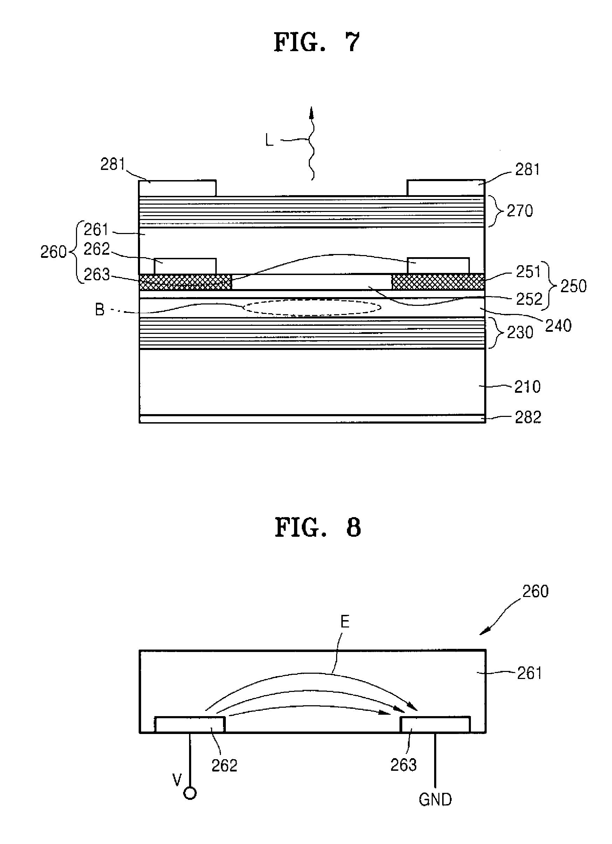

FIG. 7 is a schematic cross-sectional view of a speckle reduction laser according to another exemplary embodiment of the present invention.

Referring to FIG. 7, the speckle reduction laser according to the present exemplary embodiment has a structure in which a mode changing unit 260 is inserted into a resonance path of a semiconductor laser having a common vertical cavity surface emitting laser (VCSEL) structure.

More specifically, the speckle reduction laser according to the present exemplary embodiment has a VCSEL structure in which a lower reflection layer 230, a gain medium layer 240 that includes an active layer from which light is generated, a current control layer 250 that controls a current flow, a mode changing unit 260 that changes a resonance mode, an upper reflection layer 270, and an electrode 281 are sequentially formed on an n-type substrate 210, and an n-type electrode 282 is formed on a lower surface of the n-type substrate 210. A region B in FIG. 8 indicates a region where light is emitted from the active layer included in the gain medium layer 240. The lower and upper reflection layers 230 and 270 respectively have a semiconductor distributed bragg reflector (DBR) structure in which a plurality of layers having high refractive indexes and layers having low refractive indexes are alternately stacked. The gain medium layer 240 includes an n-type clad layer, an active layer, and a p-type clad layer. The current control layer 250 can be divided into an insulating region 251 where current is insulated, and a conductive region 252 where current flows. The speckle reduction laser according to the present exemplary embodiment is substantially identical to the structure of the VCSEL except the mode changing unit 260. Thus, the mode changing unit 260 will be mainly described.

The mode changing unit 260 according to the present exemplary embodiment includes an electro-optical material layer 261 interposed between the current control layer 250 and the upper reflection layer 270, and first and second electrodes 262 and 263 formed between the insulating region 251 of the current control layer 250 and the electro-optical material layer 261. The first and second electrodes 262 and 263 are separated from each other on the same plane of the electro-optical material layer 261. The electro-optical material layer 261, and the first and second electrodes 262 and 263 can be formed using a common semiconductor manufacturing process, and thus, the mode changing unit 260 can be formed through a batch process together with other semiconductor layers.

When a voltage V is applied to the first electrode 262, and the second electrode 263 is grounded, as depicted in FIG. 8, an electric field is applied to the electro-optical material layer 261. As described above, the electric field applied to the electro-optical material layer 261 changes the refractive index of the electro-optical material layer 261. As a result, the optical distance of an optical path corresponding to the thickness of the electro-optical material layer 261 is changed. The change of the optical distance of the optical path changes the optical resonance distance between the lower reflection layer 230 and the upper reflection layer 270, and thus, the change of the resonance mode occurs in the speckle reduction laser according to the present exemplary embodiment like in the speckle reduction laser described with reference to FIG. 1. The change of speckle patterns due to the mode change time averagely reduces the speckle contrast. Therefore, the speckle reduction laser according to the present exemplary embodiment can reduce or remove the speckles.

In the present exemplary embodiment, the mode changing unit 260 is disposed between the current control layer 250 and the upper reflection layer 270, but not limited thereto. For example, the mode changing unit 260 can be provided between the gain medium layer 240 and the current control layer 250 or alternatively, between the lower reflection layer 230 and the gain medium layer 240. Furthermore, the mode changing unit 260 may be disposed on the resonance path between the lower reflection layer 230 and the upper reflection layer 270.

Up to now, an edge emitting type laser resonance structure and a VCSEL structure, in which a mode changing unit is inserted have been described, but the present invention is not limited thereto. The present invention can be applied to any semiconductor laser in which the electro-optical material layer can be disposed in a resonance path of a laser light which is emitted by resonating light generated from an active layer in the semiconductor laser.

As described above, a speckle reduction laser according to the exemplary embodiments of the present invention can reduce speckles through a mode change which can be achieved by changing the refractive index of an electro-optical material layer disposed in a resonance path by applying a voltage to the electro-optical material layer. Furthermore, a mode changing unit that includes the electro-optical material layer can be manufactured using a common semiconductor manufacturing process without changing existing facilities. Therefore, the speckle reduction laser according to the exemplary embodiments of the present invention has low manufacturing costs.

While the speckle reduction laser according to the present invention has been particularly shown and described with reference to exemplary embodiments thereof, it will be understood by those of ordinary skill in the art that various changes in form and details may be made therein without departing from the scope of the present invention as defined by the following claims.

## Claims

1.   A speckle reduction laser that emits laser light by resonating light generated from an active layer, the speckle reduction laser comprising a mode changing unit comprising an electro-optical material layer disposed in a resonance path of the laser light, wherein a resonance mode of the laser light is changed when a voltage is applied to the electro-optical material layer.

2.   The speckle reduction laser of claim 1, further comprising a semiconductor unit, wherein the speckle reduction laser has an edge emitting type laser resonance structure in which light is emitted from a first surface of the semiconductor unit that comprises the active layer.

3.   The speckle reduction laser of claim 2, wherein a variation width of the resonance mode of the laser light is equal to or smaller than a resonance mode spacing when the variation width of the resonance mode is viewed in a frequency spectrum.

4.   The speckle reduction laser of claim 2 or 3, wherein the mode changing unit is provided on the first surface of the semiconductor unit.

5.   The speckle reduction laser of claim 4, further comprising a reflection mirror disposed on a second surface of the semiconductor unit facing the first surface of the semiconductor unit where the mode changing unit is provided.

6. The speckle reduction laser of claim 5, further comprising a half mirror on a third surface opposite to a fourth surface of the mode changing unit facing the semiconductor unit, and the laser light is emitted through the half mirror.

7. The speckle reduction laser of claim 4, 5 or 6, further comprising a reflection mirror on a third surface opposite to a fourth surface of the mode changing unit facing the semiconductor unit.

8. The speckle reduction laser of claim 7, further comprising a half mirror on a second surface opposite to the first surface of the semiconductor unit where the mode changing unit is provided, wherein the laser light is emitted through the half mirror.

9. The speckle reduction laser of claim 4, further comprising a reflection preventive member interposed between the semiconductor unit and the mode changing unit.

10. The speckle reduction laser of any of claims 4 to 9, further comprising an electrode that applies a voltage to the electro-optical material layer, and is provided on at least one of surfaces that surround a resonance path of the electro-optical material layer.

11. The speckle reduction laser of claim 10, wherein when the voltage is applied to the electro-optical material layer, electric charges are not injected into the the electro-optical material layer.

12. The speckle reduction laser of any preceding claim, wherein the speckle reduction laser has a vertical cavity surface emitting laser (VCSEL) structure in which an upper reflection layer and a lower reflection layer are respectively provided on and under the active layer.

13. The speckle reduction laser of claim 12, wherein the mode changing unit is formed on or under the active layer.

14. The speckle reduction laser of claim 13, wherein the electro-optical material layer is interposed between the active layer and the upper reflection layer.

15. The speckle reduction laser of claim 14, further comprising a current control layer that is interposed between the active layer and the electro-optical material layer, and comprises an insulating region and a conductive region, wherein an electrode that applies a voltage to the electro-optical material layer is disposed between the insulating region and the electro-optical material layer.

16. The speckle reduction laser of any preceding claim, wherein a variation width of the resonance mode of the laser light is equal to or smaller than a resonance mode spacing when the variation width of the resonance mode is viewed in a frequency spectrum.

17. The speckle reduction laser of any preceding claim, wherein the electro-optical material layer comprises at least one of K-Ta-Nb and $LiNbO_3$.

# FIG. 1

# FIG. 2

## FIG. 3

## FIG. 4

# FIG. 5

# FIG. 6

# FIG. 7

# FIG. 8

European Patent Office

**EUROPEAN SEARCH REPORT**

Application Number

EP 07 11 8240

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| P,X | WO 2007/007389 A (MITSUBISHI ELECTRIC CORP [JP]; KOYATA YASUHARU [JP]; HIRANO YOSHIHITO) 18 January 2007 (2007-01-18) * abstract * * paragraphs [0021] - [0024]; figures 2,6,7 * | 1-3,16, 17 | INV. H01S5/06 H01S5/14 ADD. H01S5/026 H01S5/183 |
| X Y | JP 57 124490 A (MITSUBISHI ELECTRIC CORP) 3 August 1982 (1982-08-03) * abstract * * page 464, right-hand column - page 465, right-hand column; figures 1,2 * | 1-11,16, 17 12-15 | |
| X Y | US 5 301 201 A (DUTTA NILOY K [US] ET AL) 5 April 1994 (1994-04-05) * column 2, line 41 - column 3, line 45; figure 1 * | 1,12-15 12-15 | |
| X Y | US 2004/160997 A1 (PETERS FRANK H [US] ET AL) 19 August 2004 (2004-08-19) * paragraphs [0017] - [0029], [0041] - [0044], [0048], [0051]; figures 1-3 * | 1,12-14, 17 12-14 | TECHNICAL FIELDS SEARCHED (IPC) H01S H04N |
| X | JP 2001 284707 A (ANRITSU CORP) 12 October 2001 (2001-10-12) * abstract * paragraphs [0006] - [0014] of the computer-generated English translation | 1,2 | |

The present search report has been drawn up for all claims

| Place of search | Date of completion of the search | Examiner |
|---|---|---|
| Munich | 2 April 2008 | Laenen, Robert |

EPO FORM 1503 03.82 (P04C01)

## ANNEX TO THE EUROPEAN SEARCH REPORT
## ON EUROPEAN PATENT APPLICATION NO.

EP 07 11 8240

This annex lists the patent family members relating to the patent documents cited in the above-mentioned European search report.
The members are as contained in the European Patent Office EDP file on
The European Patent Office is in no way liable for these particulars which are merely given for the purpose of information.

02-04-2008

| Patent document cited in search report | | Publication date | Patent family member(s) | | Publication date |
|---|---|---|---|---|---|
| WO 2007007389 | A | 18-01-2007 | NONE | | |
| JP 57124490 | A | 03-08-1982 | JP | 1433778 C | 07-04-1988 |
| | | | JP | 62043353 B | 12-09-1987 |
| US 5301201 | A | 05-04-1994 | DE | 69404701 D1 | 11-09-1997 |
| | | | DE | 69404701 T2 | 26-02-1998 |
| | | | EP | 0614256 A1 | 07-09-1994 |
| | | | JP | 6318765 A | 15-11-1994 |
| US 2004160997 | A1 | 19-08-2004 | JP | 2004247730 A | 02-09-2004 |
| JP 2001284707 | A | 12-10-2001 | NONE | | |

EPO FORM P0459

For more details about this annex : see Official Journal of the European Patent Office, No. 12/82